# FASCICULE DE BREVET EUROPEEN

(11) **EP 2 823 441 B1**
(45) Date de publication et mention de la délivrance du brevet: **12.06.2019**
(21) Numéro de dépôt: 13709788.7
(22) Date de dépôt: 21.02.2013
(51) Int. Cl.: G06M 11/00, G06M 1/10

(54) **PROCEDE ET DISPOSITIF DE COMPTAGE D'OBJETS**
VERFAHREN UND VORRICHTUNG ZUR ZÄHLUNG VON OBJEKTEN
PROCEDURE AND DEVICE FOR COUNTING OBJECTS

(30) Priorité: 06.03.2012 FR 1252025
(43) Date de publication de la demande: 14.01.2015
(73) Titulaire: Commissariat à l'Énergie Atomique et aux Énergies Alternatives, 75015 Paris (FR); ISORG, 38000 Grenoble (FR)
(72) Inventeur: SEGURA PUCHADES, Josep, F-38600 Fontaine (FR); PREMONT, Christophe, F-38360 Sassenage (FR)
(74) Mandataire: Bréda, Jean-Marc
(86) Numéro de dépôt international: PCT/EP2013/053417
(87) Numéro de publication internationale: WO 2013/131750

(56) Documents cités:
- FR-A1- 2 400 734

## Description

L'invention concerne le comptage d'objets par une méthode de détection optique directe.

La détection d'objets par des méthodes optiques peut faire appel à des moyens plus ou moins sophistiqués, comprenant notamment une prise de vue avec un capteur d'image électronique et un traitement ultérieur complexe de l'image (reconnaissance de formes, etc.) pour effectuer un comptage d'objets présents dans l'image, comme décrit dans le document FR 2 400 734.

On propose ici une méthode de comptage plus simple et plus directe, et un dispositif de comptage correspondant, pour des applications telles que le comptage d'objet posés sur une surface.

Selon l'invention, on propose
- d'utiliser un ensemble photosensible comprenant au moins un élément photoconducteur, et une source d'éclairement uniforme pour éclairer l'ensemble photosensible,
- de déterminer une référence de courant fourni par l'ensemble photosensible pour une zone éclairée de cet ensemble correspondant à une surface élémentaire qui est une fraction déterminée de la surface de l'ensemble photosensible,
- de disposer les objets à compter contre l'ensemble photosensible, d'éclairer l'ensemble photosensible par la source, les objets posés masquant une partie de la surface de l'ensemble photosensible,
- de mesurer le courant fourni par l'ensemble, et de déterminer la surface masquée par les objets, et en conséquence le nombre d'objets, à partir du courant mesuré et de la référence de courant.

L'élément photoconducteur est de préférence une photodiode mais peut être une photorésistance.

Les objets qu'on veut compter seront en général inanimés, mais l'invention s'applique aussi au comptage de corps vivants tels que des colonies de bactéries dans une boîte de Pétri (boîte avec couvercle transparent) ; le mot objet dans le contexte de cette invention désignera aussi bien des corps vivants que des objets inanimés.

L'invention est particulièrement utilisable avec un ensemble photosensible constitué par une feuille revêtue d'un matériau photoconducteur organique imprimé et de conducteurs permettant de recueillir un courant dû à l'éclairement. La feuille est de préférence une feuille souple de petite ou de grande dimension (par feuille de grande dimension, on entendra une feuille d'au moins dix centimètres de côté et de préférence plusieurs dizaines de centimètres de côté). Une telle feuille est posée par exemple sur une surface plane et les objets sont posés sur la feuille. Une plaque d'éclairement diffusant une lumière uniforme est disposée au-dessus de la feuille. Par exemple, la feuille est posée sur le fond d'un tiroir et la plaque éclairante ferme la surface supérieure du tiroir ; ou encore la feuille est disposée dans le fond d'un récipient ou sous le récipient s'il est transparent et la plaque éclairante est disposée au-dessus du récipient ou au-dessus d'un couvercle transparent.

Dans la version préférée de l'invention, l'ensemble photosensible comprend une matrice de N lignes et P colonnes d'éléments photoconducteurs ou pixels (N et P entiers supérieurs ou égaux à 1). C'est une matrice passive composée d'un réseau de conducteurs de lignes et de conducteurs de colonnes, avec un élément photoconducteur (de préférence une photodiode) disposé à chaque croisement entre un conducteur de ligne et un conducteur de colonne ; cet élément ou cette photodiode correspond à un pixel photosensible. Une colonne de référence de la matrice, placée de préférence sur un bord de la matrice photosensible, est uniformément éclairée (aucun objet posé sur cette colonne) à l'exception d'un nombre connu k (k entier ou nul) de surfaces élémentaires non éclairées. La surface élémentaire peut être la surface d'un pixel. Cette colonne sert à déterminer le courant de référence correspondant à l'éclairement d'un seule surface élémentaire ou pixel ; elle fournit un courant I_{M} et le courant de référence correspondant à un seul pixel éclairé est I_{M}* /(N-k). Le nombre k peut à la limite être égal à 0 (la colonne de référence est entièrement éclairée). On préfère cependant faire une mesure par différence avec deux colonnes de référence qui sont une colonne ayant k surfaces élémentaires masquées (k pixels noirs) et l'autre ayant k' surfaces élémentaires masquées, k' entier différent de k. La différence de courant des deux colonnes représente k'-k fois le courant de référence d'une surface élémentaire, ce qui permet de déterminer le courant élémentaire généré par l'éclairement d'une seule surface élémentaire.

Les colonnes de référence peuvent être dupliquées (présence de colonnes de référence par exemple à la fois sur le bord droit et sur le bord gauche de la matrice) et les courants de deux colonnes dupliqués sont moyennés pour tenir compte éventuellement d'une non-uniformité d'éclairement.

Les circuits de lecture, associés à chaque colonne, sont de préférence différentiels, c'est-à-dire qu'on mesure la différence de courant entre une colonne de référence, par exemple une colonne totalement éclairée (ou totalement noire) et l'autre colonne, associée au circuit de lecture, étant éclairée mais ayant des pixels masqués par un objet à compter ou, pour une colonne de référence, des pixels masqués par une couche opaque.

On peut déterminer un nombre d'objets colonne par colonne, mais on peut aussi effectuer une mesure globale du courant photogénéré par toute la matrice afin d'obtenir un nombre d'objets global posé sur la matrice.

Si la matrice de photodiodes est pourvue non seulement de circuits de lecture en colonne mais aussi de circuits de lecture en ligne, c'est-à-dire un circuit de lecture à l'extrémité de chaque ligne, on peut faire la lecture soit en colonne soit en ligne et on peut établir des histogrammes de répartition en ligne et en colonne des pixels masqués par des objets. Il faut pour cela pouvoir alimenter les photodiodes par les conducteurs de ligne lorsqu'on fait une mesure sur les colonnes et par les conducteurs de colonne lorsqu'on fait une mesure sur les conducteurs de ligne, en inversant le sens des potentiels d'alimentation.

Dans une version simplifiée, on n'a pas une matrice de photodiodes mais seulement des colonnes de photodiodes, chaque photodiode; de forme très allongée, étant constituée à partir d'une colonne entière de matériau photosensible fonctionnant comme une seule photodiode. La lecture ne peut se faire qu'en colonne, à partir de circuits de lecture associés aux colonnes, l'alimentation se faisant par un conducteur de ligne unique. La surface élémentaire qui sert à déterminer un courant de référence est alors une fraction seulement de la colonne.

Enfin, dans une version extrêmement simplifiée, l'ensemble photosensible n'est pas subdivisé en plusieurs photodiodes pouvant être lues individuellement. Il est au contraire constitué par une seule vaste photodiode dont on lit le courant globalement engendré par l'éclairement. Cet ensemble peut fonctionner à condition de le calibrer. La calibration se fait en deux temps : mesure du courant fourni lorsque la totalité de la photodiode est éclairée, et mesure du courant lorsque une (ou plusieurs) fraction(s) (ou surfaces élémentaires) connues de la surface (également connue) de la photodiode est masquée. On peut tout simplement faire une mesure de courant sans aucune surface élémentaire masquée, puis une mesure de courant après avoir posé un objet ayant les caractéristiques des objets à compter. La surface élémentaire est alors la surface de l'objet. On détermine par différence le courant de référence correspondant à l'éclairement de cette surface. Puis, on fait la mesure du courant lorsque des objets sont posés sur la surface.

L'invention concerne non seulement cette méthode de comptage et ses variantes mais aussi un dispositif de comptage correspondant, comportant une matrice passive de N lignes et P colonnes (N et P supérieurs ou égaux à 1) d'éléments photoconducteurs, notamment des photodiodes, contre laquelle on peut placer les objets pour masquer en partie la matrice, une source de lumière uniforme qui éclaire l'ensemble photosensible, des moyens de détermination d'un courant élémentaire correspondant à l'éclairement d'une surface élémentaire qui est une fraction de la surface de la matrice, des moyens de mesure d'au moins un courant délivré par la matrice en présence d'objets masquant en partie la matrice, et des moyens de calcul pour déterminer la surface masquée par les objets puis le nombre d'objets à partir du courant délivré et du courant élémentaire. Selon la présente invention, il est proposé une méthode de comptage d'objets et un dispositif correspondant, comme défini dans les revendications indépendantes 1 et 12. Les modes de réalisation préférés sont définis dans les revendications dépendantes 2-11.

D'autres caractéristiques et avantages de l'invention apparaîtront à la lecture de la description détaillée qui suit et qui est faite en référence aux dessins annexés dans lesquels :
- la figure 1 représente symboliquement en perspective une matrice de pixels photosensibles sur laquelle sont posés des objets qui masquent des pixels ;
- la figure 2 représente une vue en plan d'une telle matrice ;
- la figure 3 représente un schéma électrique d'une matrice passive de photodiodes et les circuits de lecture associés ;
- la figure 4 représente la matrice avec des colonnes de référence différentes de celles de la figure 2 ;
- la figure 5 représente la matrice avec les colonnes de référence dupliquées n;
- la figure 6 représente une matrice avec des circuits de lecture associés à chaque colonne de pixels ;
- la figure 7 représente une matrice avec un multiplexage de la lecture des colonnes de pixels ;
- la figure 8 représente une variante de réalisation de la figure 7 ;
- la figure 9 représente un schéma explicatif d'un calcul d'histogramme en colonne ;
- la figure 10 représente un schéma explicatif d'histogramme en colonne et en ligne ;
- la figure 11 représente une matrice dont les colonnes ne sont pas subdivisées en pixels individuels ;
- la figure 12 représente l'ensemble photosensible constitué par une seule photodiode de larges dimensions, avec deux étapes de calibration (12a, 12b) et une étape de mesure (12c).
- la figure 13 et la figure 14 représentent l'ensemble photosensible avec des objets qui ne sont pas posés précisément sur les pixels de la matrice.

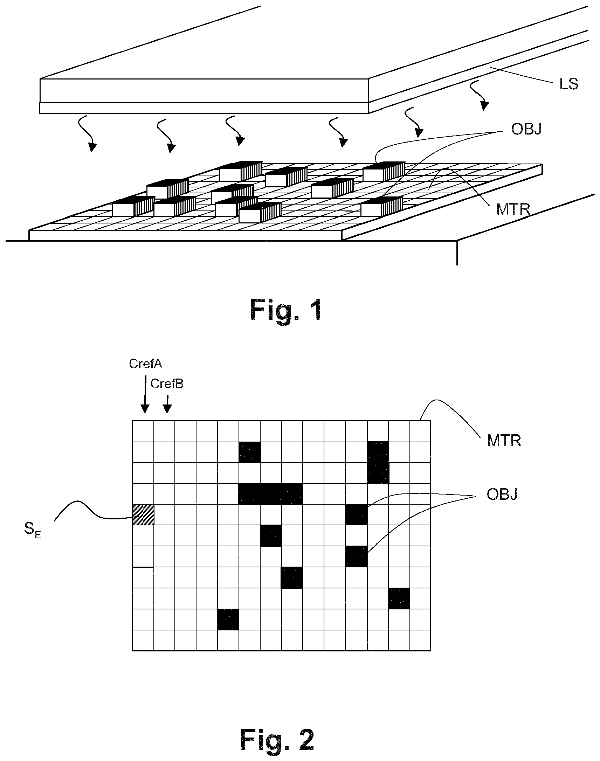

Sur la figure 1, on voit en vue perspective un ensemble photosensible qui est symbolisé par une matrice MTR de N lignes et P colonnes de pixels, soit NxP pixels. La matrice est éclairée uniformément par une source d'éclairement LS.

Des objets OBJ à compter, tous identiques, sont posés sur la matrice. Ils masquent les pixels sur lesquels ils reposent, c'est-à-dire que la lumière de la source LS ne parvient pas à ces pixels. Les autres pixels sont éclairés par la source.

Pour simplifier les explications, on a représenté les objets comme ayant une forme parallélépipédique de mêmes dimensions que les pixels, chaque objet recouvrant en totalité un pixel et un seul. On verra que cette identité de forme et dimensions entre le pixel et l'objet à compter n'est pas absolument obligatoire, pourvu qu'on connaisse la surface recouverte par un objet à compter. La surface d'un pixel donne la résolution avec laquelle on peut détecter les surfaces d'objets posés sur la matrice : plus elle est petite, mieux on peut compter des petits objets et plus le compte des plus grands objets est précis. La surface recouverte par un objet peut donc recouvrir plusieurs pixels de la matrice.

La source de lumière comprend de préférence une plaque diffusante semblable à la boîte à lumière d'un afficheur à cristal liquide. Cette plaque a de préférence la même surface que la matrice.

La matrice photosensible est une matrice passive de grande dimension. Typiquement elle comprend une structure sandwich comprenant une feuille de substrat de préférence en matière plastique souple, revêtue d'un matériau photoconducteur, de préférence organique et déposé par une méthode d'impression, entre un réseau de conducteurs de face arrière et un réseau de conducteurs de face avant. Les conducteurs de face avant sont de préférence transparents (en oxyde d'indium étain ITO) ou bien doivent être très étroits pour ne pas trop masquer le matériau photosensible ; les conducteurs de face arrière n'ont pas besoin d'être transparents. Les conducteurs de face arrière peuvent être des conducteurs de ligne et les conducteurs de face avant peuvent être des conducteurs de colonne, ou le contraire. Si tous les conducteurs de ligne sont alimentés simultanément par un même potentiel, ils peuvent être rassemblés en une seule couche conductrice globale occupant l'essentiel de la surface de la feuille.

Les conducteurs ne sont pas représentés sur la figure 1 pour ne pas alourdir la figure.

Une portion de matériau photoconducteur située au croisement d'un conducteur de ligne et d'un conducteur de colonne définit un pixel photosensible et se comporte comme une photorésistance ou de préférence une photodiode connectée entre le conducteur de ligne et le conducteur de colonne. Le conducteur de ligne est alimenté par une tension de polarisation et le conducteur de colonne est relié à un circuit de lecture associé à la colonne. Le circuit de lecture lit le courant de chaque colonne, c'est-à-dire la somme des courants des photodiodes qui sont reliées à ce conducteur de colonne et qui sont polarisées par ailleurs par la tension de polarisation. Chaque photodiode qui est polarisée par un conducteur de ligne laisse en effet passer vers le conducteur de colonne un courant qui dépend de l'éclairement de cette photodiode.

Dans l'invention, on ne cherche pas à obtenir une image globale des objets posés sur la feuille photosensible ; on cherche seulement à compter les objets. Par conséquent il n'est pas nécessaire d'alimenter successivement les lignes une par une pour observer le courant qui en résulte à chaque fois sur chacune des colonnes. Au contraire on alimente globalement toutes les lignes à la fois par une même tension de polarisation Vpol et on lit le courant résultant sur chaque colonne. Ce courant dépend du nombre de pixels masqués dans la colonne par un ou plusieurs objets.

Dans ce qui suit, on parlera pour simplifier de matrice de photodiodes même si le matériau photosensible n'est pas véritablement constitué par deux couches semiconductrices de types opposés P et N comme c'est le cas dans les photodiodes classiques. On sait en effet aujourd'hui réaliser des éléments organiques qui se comportent comme des photodiodes mais qui ne comportent qu'une seule couche de matériau, des micro-jonctions PN s'établissant à l'intérieur du matériau.

La figure 2 est une représentation simplifiée, vue de dessus, de la matrice de pixels dans laquelle les carrés blancs représentent des pixels éclairés par la source uniforme et les carrés noirs représentent des pixels masqués par un objet recouvrant le pixel et ayant les mêmes dimensions que le pixel. Un carré hachuré sur lequel on reviendra plus loin représente un pixel masqué par une couche opaque. Ce carré a une surface élémentaire S_{E}. C'est par rapport à cette surface qu'on définit la surface d'un objet posé. En connaissant le nombre de surfaces élémentaires masquées par un seul objet et en mesurant le nombre de surfaces élémentaires masquées sur la matrice, on déterminera le nombre d'objets posés.

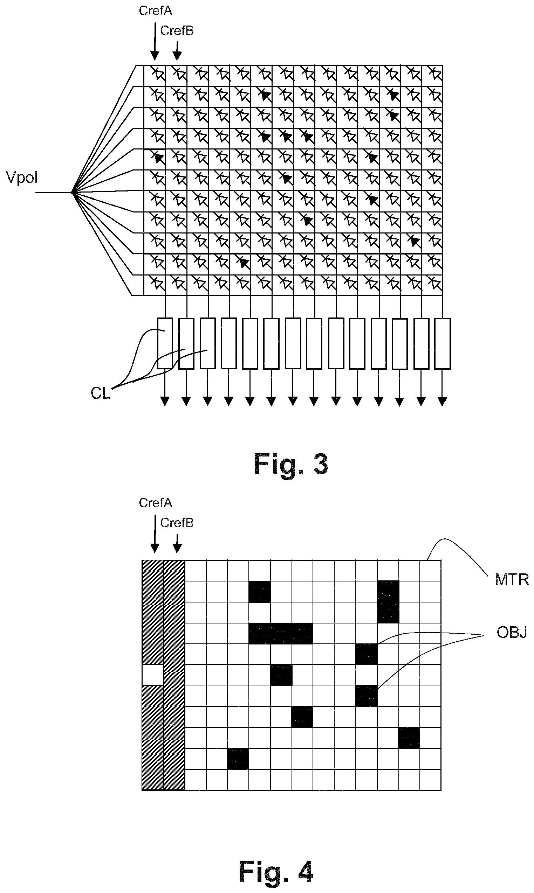

La figure 3 est une représentation de la même matrice, sous forme d'un réseau matriciel passif de photodiodes dans lequel les cathodes des photodiodes d'une même ligne sont connectées à un même conducteur de ligne et les anodes d'une même colonne sont toutes reliées à un même conducteur de colonne respectif. Chaque photodiode au croisement d'un conducteur de ligne et d'un conducteur de colonne représente un pixel de la matrice MTR.

La tension de polarisation Vpol est appliquée à tous les conducteurs de ligne réunis, et le circuit de lecture est porté à un potentiel plus négatif que la tension Vpol de manière à polariser les photodiodes en inverse. On pourrait inverser les potentiels et les sens des photodiodes, les photodiodes étant toujours polarisées en inverse afin que le courant fourni par la photodiode à un conducteur de colonne soit toujours un courant de polarisation inverse de photodiode, ce courant dépendant de l'éclairement.

Les photodiodes éclairées sont représentées en blanc. Les photodiodes non éclairées, parce que masquées par un objet, sont représentées en noir.

Comme on le voit sur la figure 3, il y a un circuit de lecture CL par colonne de pixels ; ce circuit mesure le courant fourni par le conducteur de colonne, courant qui est la somme des courants des photodiodes de la colonne.

De manière générale, on détermine le nombre d'objets posés sur chaque colonne à partir d'un calcul du nombre de pixels d'une colonne qui ne sont pas éclairés par la source du fait qu'ils sont masqués par un objet. Ce calcul est fait en mesurant le courant I_{M} produit par la colonne. Le nombre de pixels éclairés est N-n, lorsque le nombre de pixels masqués est n. Si on connaît le courant élémentaire I_{E} produit par un pixel éclairé, alors le courant produit par N-n pixels éclairés est (N-n)I_{E} ; le nombre de pixels masqués dans la colonne fournissant un courant I_{M} est n = N - I_{M}/I_{E}- Si on appelle nᵢ le nombre calculé pour la colonne de rang i, le nombre total de pixels masqués dans la matrice MTR est la somme n_{T} des nᵢ, i variant de 1 à P.

Dans le cas le plus simple (figures 1 et 2) il y a autant d'objets que de pixels masqués. Dans les cas moins simples (objets disposés en partie à cheval sur un ou plusieurs pixels ou objets plus petits ou plus grands qu'un pixel) on peut faire une approximation plutôt qu'un calcul exact, cette approximation étant faite à partir du nombre n_{T} et du rapport entre la surface d'un objet et la surface d'un pixel.

Dans une première réalisation de l'invention, correspondant aux figures 2 et 3, on utilise deux colonnes de référence de la matrice, l'une (CrefA) ayant un ou plusieurs pixels artificiellement masqués, par exemple par une couche opaque locale, l'autre (CrefB) n'ayant aucun pixel masqué, ni par une couche opaque ni par un objet. On s'interdit de déposer un objet à compter sur ces colonnes de référence. La différence entre le courant I_{refB} de la colonne CrefB et le courant I_{refA} de la colonne CrefA représente le courant moyen I_{E} fourni par un pixel. Si k pixels (k>1) sont masqués dans la colonne CrefA il faut diviser par k la différence des courants des colonnes CrefB et CrefA pour obtenir le courant moyen I_{E}.

Le nombre nᵢ de pixels masqués dans une colonne de rang i est obtenu en divisant par I_{E} la différence entre le courant I_{refB} de la colonne et le courant Iₘᵢ mesuré par le circuit de lecture de la c olonne de rang i).

Cette mesure par différence supprime la contribution du courant d'obscurité des photodiodes, en supposant que ce courant est à peu près uniforme pour toutes les photodiodes de la matrice.

Le courant de la colonne entièrement éclairée peut servir à déterminer l'éclairement moyen de la matrice supposée éclairée uniformément. On peut s'en servir à des fins d'asservissement de la source de lumière. Il pourrait servir aussi, si on le divise par le nombre N de pixels dans la colonne, à déterminer le courant moyen I_{E} d'un pixel, mais il est préférable de déterminer ce courant par différence entre les courants des colonnes de référence CrefA et CrefB, afin de supprimer la contribution du courant d'obscurité et les dérives temporelles de la réponse des photodiodes et/ou de l'éclairage.

Dans une deuxième réalisation, représentée à la figure 4, la première colonne de référence CrefA comporte N-1 pixels masqués, par exemple par une couche opaque déposée à sa surface, et un seul pixel éclairé ; la deuxième colonne de référence CrefB comporte tous les N pixels masqués par une couche opaque. La différence entre les courants de la colonne CrefA et la colonne CrefB donne directement le courant élémentaire I_{E} d'un pixel éclairé. Les courants des autres colonnes sont divisés par I_{E} pour avoir le nombre de pixels éclairés ; le complément à N donne le nombre de pixels masqués dans la colonne. On pourrait aussi avoir k pixels masqués dans la colonne CrefA au lieu d'un seul. Il faut diviser la différence de courants par k pour avoir le courant de référence d'un pixel. On pourrait aussi avoir k pixels masqués dans une des colonnes et k' pixels masqués dans l'autre, la différence de courant devant être divisée par k' pour avoir la référence.

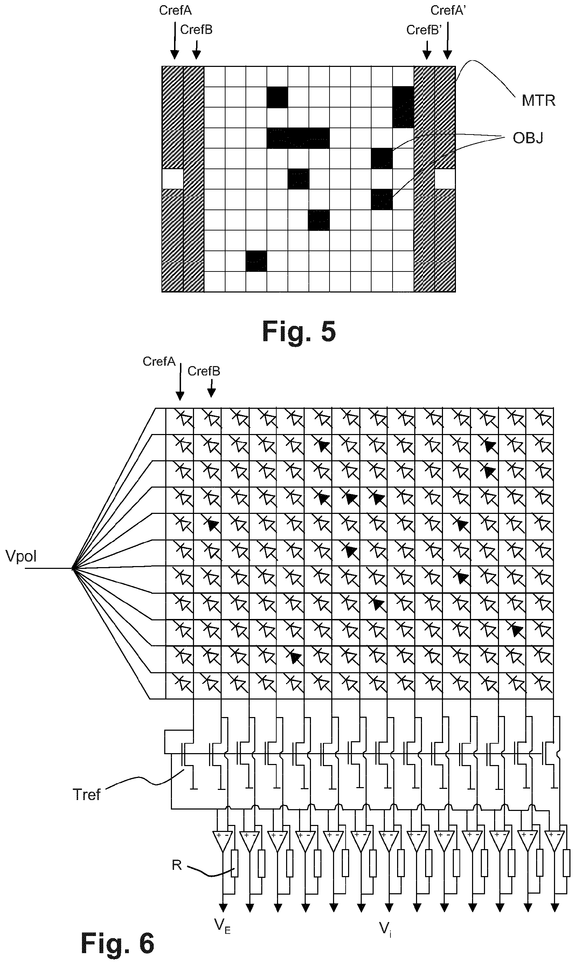

Dans les deux réalisations précédentes, on peut compenser les effets d'une non-uniformité d'éclairement en dupliquant les colonnes de référence, par exemple en plaçant une paire de colonnes de référence CrefA, CrefB à gauche de la matrice, et une autre paire, CrefA', CrefB', à droite de la matrice comme le représente la figure 5. On moyenne les résultats des deux colonnes pour obtenir le courant élémentaire I_{E}.

Les circuits de lecture sont des circuits de lecture en courant, le courant délivré par les photodiodes polarisées en inverse étant une bonne représentation de l'éclairement. Mais les courants peuvent être convertis en tension pour pouvoir être plus facilement convertis par un convertisseur analogique-numérique (non représenté) afin de faire les calculs de nombre d'objets posés.

Une solution particulièrement intéressante pour la mesure du courant et la conversion en tension consiste à utiliser le courant d'une colonne de référence et le recopier dans les autres colonnes de référence pour appliquer à chaque circuit de lecture associé à une colonne non pas le courant de cette colonne mais la différence entre le courant de cette colonne et le courant de la colonne de référence.

La figure 6 représente une telle réalisation, dans laquelle la colonne de référence qui sert à établir le courant à recopier est une colonne CrefA dont tous les pixels sont éclairés. Le conducteur de colonne correspondant est relié au drain d'un transistor de référence Tref monté en diode, dont la grille est reliée au drain et dont la source est à un potentiel de masse. Il n'y a pas véritablement de circuit de lecture associé à cette colonne, autre que ce transistor qui reçoit la totalité du courant de la colonne CrefA. Le courant dans ce transistor est égal à N.I_{E} si les N pixels de la colonne de référence sont entièrement éclairés. Ce courant est recopié par un transistor de recopie respectif de chaque circuit de lecture associé à une colonne. Pour cela, le transistor de recopie a sa source reliée à la masse et sa grille reliée à la grille du premier transistor. Le drain du transistor de recopie n'est pas relié à sa grille ; il est relié au conducteur de colonne correspondant à ce circuit de lecture et il est relié par ailleurs à une entrée inverseuse d'un amplificateur opérationnel. L'entrée non inverseuse de l'amplificateur est reliée à la grille du transistor de référence et donc aux grilles des transistors de recopie. Cette configuration permet une recopie fiable du courant en polarisant chaque drain à la tension de grille du transistor de référence par l'action de contre-réaction de l'amplificateur opérationnel. L'amplificateur opérationnel est rebouclé entre sa sortie et son entrée inverseuse par une résistance de valeur R (la même valeur pour tous les circuits).

Le transistor de référence tire du conducteur de colonne de référence un courant N.I_{E}, et le transistor de recopie tire un courant identique de la colonne à laquelle il est relié. Mais comme le courant délivré par les photodiodes de cette colonne est (N-nᵢ)I_{E} s'il y a nᵢ pixels masqués dans la colonne de rang i, la différence entre ces deux courants est évacuée vers l'amplificateur opérationnel. Le courant circulant dans la résistance de bouclage est la différence entre ces deux courants, soit nᵢ.I_{E}. La tension développée aux bornes de la résistance R d'un circuit de lecture est Vᵢ = R.nᵢI_{E}. Elle est proportionnelle au nombre nᵢ de pixels masqués dans la colonne.

L'amplificateur associé à la deuxième colonne de référence CrefB fournit une tension de référence V_{E} = R.I_{E}. Le nombre nᵢ est obtenu par le rapport de ces tensions Vᵢ et V_{E}.

Les tensions peuvent être converties par un convertisseur analogique-numérique (non représenté) pour permettre ensuite une division numérique facile.

Le circuit de lecture individuel servant à déterminer le nombre de pixels masqués dans une colonne est individuel pour chaque colonne. Toutefois, pour des raisons d'encombrement on peut préférer faire un multiplexage temporel de la lecture, en dirigeant les courants issus de chaque colonne successivement vers un seul circuit commun de conversion courant-tension comprenant par exemple l'amplificateur opérationnel et la résistance de la figure 6. Les tensions de sortie sont alors lues successivement et non simultanément.

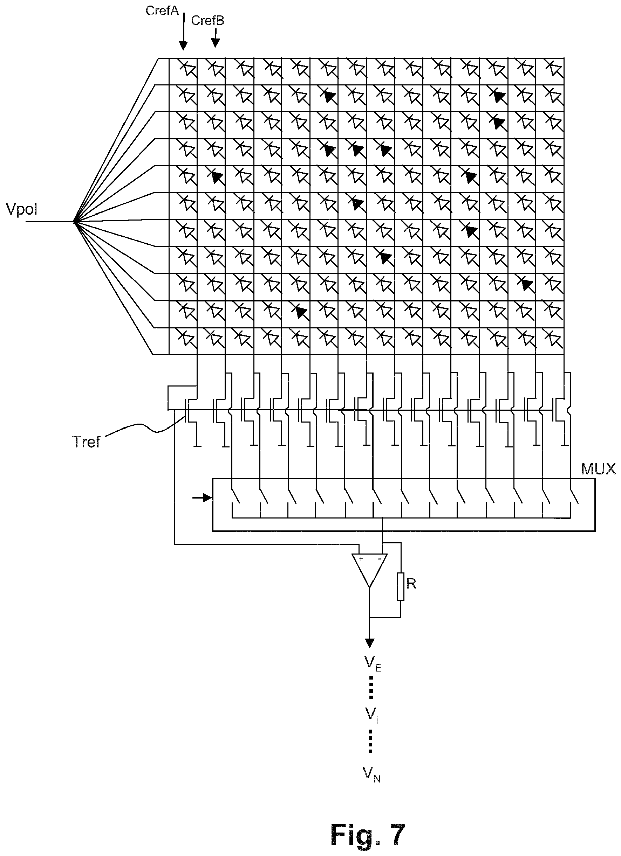

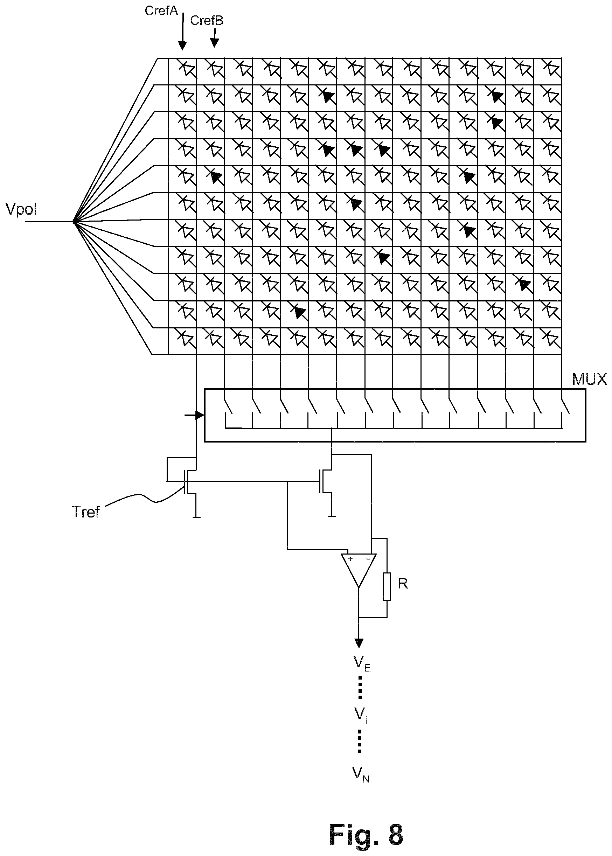

Le multiplexeur MUX peut être placé en aval des transistors de recopie des N-1 colonnes autres que la colonne CrefA, comme représenté sur la figure 7 ; le circuit de lecture associé à une colonne comprend alors le transistor de recopie et l'aiguillage du multiplexeur, et l'amplificateur et la résistance sont partagés entre tous les circuits de lecture. Le multiplexeur MUX peut aussi être placé en amont, et dans ce cas il n'y a qu'un seul transistor de recopie, placé entre la sortie du multiplexeur et l'entrée de l'amplificateur, comme cela est représenté sur la figure 8.

Une capacité peut être mise en parallèle sur la résistance de bouclage de l'amplificateur pour filtrer les transitions lors des commutations du multiplexeur.

On pourrait aussi prévoir, à la place d'un système de recopie de courant, que les conducteurs de colonne sont reliés directement à un multiplexeur. Le multiplexeur sélectionne successivement chaque colonne sous la commande d'un simple registre à décalage, et il dirige alors ce courant et lui seul vers un circuit de lecture unique. La première colonne de référence est d'abord sélectionnée, puis la deuxième ; le courant de référence est calculé par différence. Puis les autres colonnes sont sélectionnées l'une après l'autre pour une mesure directe de leur courant.

### Génération d'histogrammes en colonne

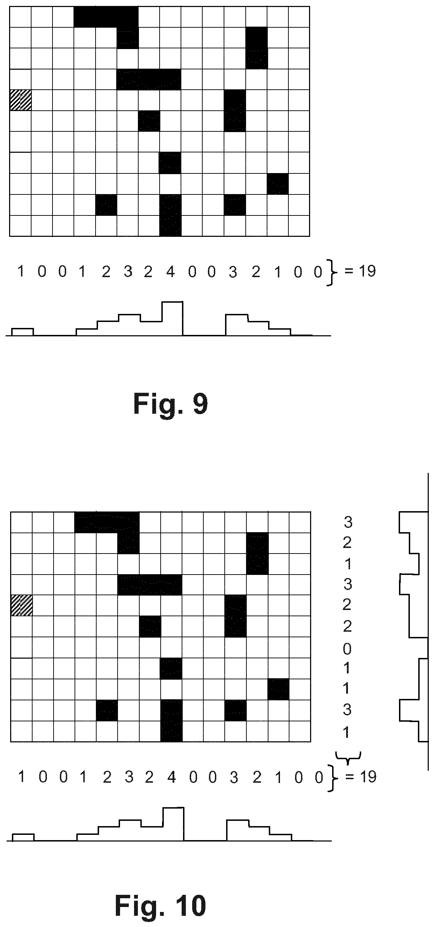

Le principe décrit précédemment permet de déterminer le nombre d'objets posés dans chaque colonne de la matrice. On peut donc tracer un histogramme par colonne, c'est-à-dire une courbe dont l'abscisse est le numéro de la colonne et l'ordonnée est le nombre d'objets posés dans la colonne. La figure 9 représente schématiquement le résultat de ce calcul d'histogramme.

Mais si on est intéressé seulement par le nombre total des objets posés sur la matrice on peut prévoir de lire simultanément toutes les colonnes pour mesurer le courant total généré par les photodiodes. Dans ce cas on peut, après avoir déterminé le courant élémentaire généré par un pixel éclairé, connecter ensemble toutes les colonnes (tous les interrupteurs du multiplexeur étant activés en même temps) à l'amplificateur de lecture, mesurer la tension de sortie et en déduire le nombre total de pixels masqués donc d'objets posés ; à noter qu'un pixel non éclairé provient du pixel hachuré de la colonne de référence CrefB des figures 6 à 8 et non pas d'un objet posé.

### Génération d'histogrammes en colonne et en ligne

Si on veut déterminer le nombre de pixels en ligne, il faut pouvoir inverser les rôles des lignes et des colonnes. Cela veut dire
- qu'il faut prévoir des circuits de lecture connectés aux extrémités des lignes, et pas seulement aux extrémités des colonnes
- qu'il faut prévoir des moyens d'application d'une tension de polarisation inversée -Vpol sur les colonnes à la place de la tension de polarisation Vpol sur les lignes
- qu'il faut prévoir que les circuits de lecture des lignes sont adaptés à une inversion générale des tensions et des courants par rapport à ceux qui sont utilisés pour la lecture en colonne.

Si c'est le cas, on peut générer par calcul un histogramme en colonne et un histogramme en ligne. La figure 10 représente schématiquement ces histogrammes en ligne et en colonne.

### Photodiodes décomposées en colonnes mais pas en lignes

S'il n'y a qu'une ligne de photodiodes et que chaque photodiode est allongée sur toute la hauteur de la feuille photosensible, on peut encore effectuer le comptage d'objets.

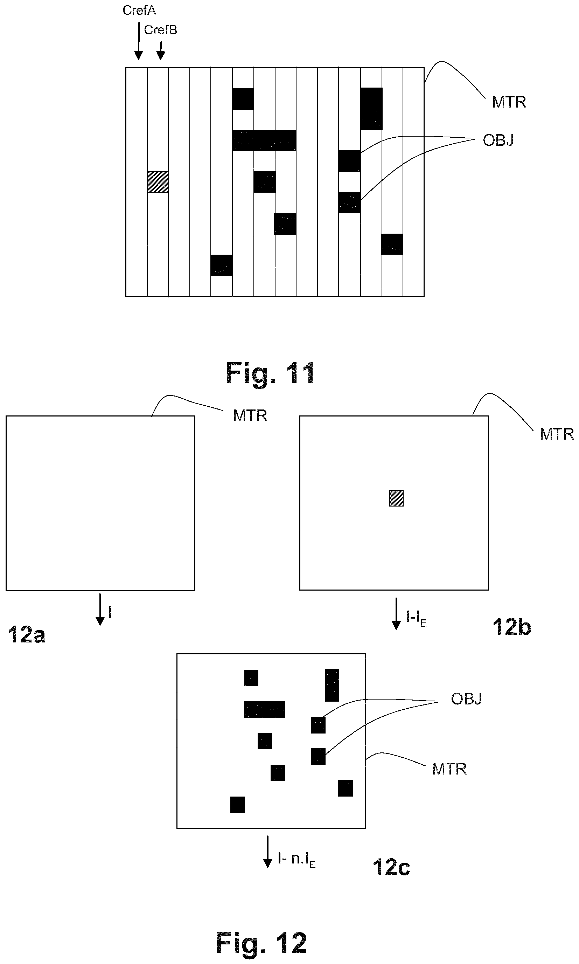

La surface élémentaire qui définit la résolution de la mesure est égale à la largeur de la colonne multipliée par une fraction de la hauteur de la colonne. La colonne de référence CrefB qui va servir à déterminer le courant élémentaire doit donc être masquée sur cette fraction de surface de colonne, comme cela est indiqué par la surface hachurée de la figure 11. L'autre colonne de référence CrefA est complètement éclairée et aucun objet ne repose sur elle.

Pour compter le nombre d'objets posés, on effectue exactement la même mesure que dans les cas précédents : on détermine, par différence entre les mesures des colonnes de référence, le courant élémentaire I_{E} qui serait généré par la fraction hachurée seule si elle était éclairée. Cette fraction correspond de préférence à la surface d'un objet à détecter, comme dans le cas des figures précédentes. Puis on mesure globalement ou colonne par colonne les courants générés en présence des objets posés et on les compare au courant de référence pour calculer colonne par colonne ou globalement le nombre de surfaces élémentaires masquées. La différence par rapport aux figures précédentes est seulement le fait que les photodiodes ne sont pas subdivisées en plusieurs pixels dans le sens de la hauteur.

Un histogramme en colonnes reste possible, mais pas un histogramme en ligne puisqu'il n'y a plus qu'une ligne.

### Utilisation d'une seule photodiode de grande dimension

On peut même prévoir qu'il n'y aucune décomposition de la feuille photosensible en photodiodes élémentaires adressables en lignes et en colonne.

Dans ce cas, il faut effectuer un calibrage préalable pour déterminer le courant élémentaire correspondant à une surface éclairée qui est égale à la surface élémentaire d'un objet à compter (ou une surface plus petite si on souhaite une meilleure résolution dans le comptage).

Par conséquent on effectue une première mesure en éclairant toute la photodiode ; puis une deuxième mesure en masquant une surface élémentaire. On en déduit par différence le courant I_{E} généré par l'éclairement de cette surface élémentaire. Puis on pose les objets et on mesure le courant global délivré par la photodiode. Par une division par I_{E} on en déduit le nombre de surfaces élémentaires masquées donc le nombre d'objets.

La figure 12 représente les trois étapes de cette mesure. La première étape (12a) donne une mesure de courant I lorsque la totalité de la photodiode est éclairée; la deuxième étape (12b) est faite en masquant une surface élémentaire qui peut être située n'importe où dans la photodiode, ici par exemple au centre ; elle donne un courant I-I_{E} ; la troisième étape (12c) donne un courant I-n.I_{E}, n étant le nombre d'objets à compter, exprimé en multiple de la surface élémentaire masquée à la deuxième étape. On fait la différence entre la première étape et la deuxième pour avoir I_{E}, et la différence entre la première étape et la troisième pour avoir n.I_{E}. Le rapport donne le nombre total de surfaces élémentaires masquées, d'où on peut déduire le nombre d'objets posés.

### Objets ne coïncidant pas avec le réseau de photodiodes

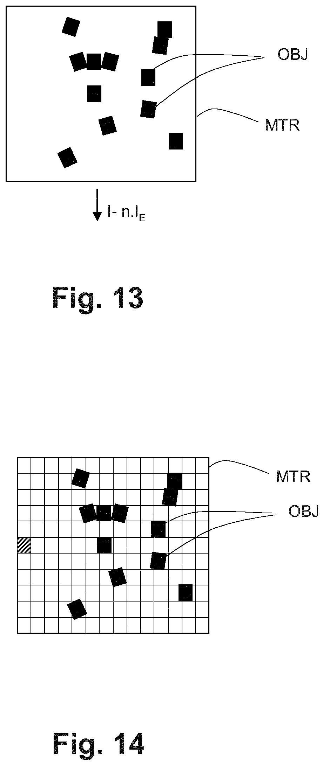

La figure 13 représente le cas d'une seule photodiode de grande dimension, sur laquelle les objets sont posés sans préoccupation de leur position ; il est clair qu'on peut encore compter les objets : il n'y a aucun changement par rapport à la figure 11 qui représentait les objets posés selon une organisation matricielle précise.

Mais même si la photodiode est décomposée en colonnes et en lignes, on peut compter les objets mal disposés par rapport au réseau, c'est-à-dire des objets qui seraient à cheval sur deux lignes et/ou deux colonnes. La seule chose est que le comptage des objets en ligne et en colonne sera moins précis. On obtiendra pour chaque colonne des valeurs de nombre nᵢ qui peuvent ne pas être entiers mais plutôt fractionnaires ; on additionnera ces valeurs fractionnaires pour obtenir la meilleure approximation entière possible pour le nombre total d'objets posés sur la matrice. La figure 14 représente une matrice sur laquelle les objets sont tournés ou décalés par rapport aux colonnes de pixels (et éventuellement aux lignes, mais les lignes n'ont pas d'importance si la lecture est faite en colonne).

### Résolution

Pour obtenir une résolution désirée, c'est-à-dire une capacité à compter des petits objets pour une surface donnée de la feuille photosensible, il faut décomposer la surface de la feuille en surfaces élémentaires suffisamment petites. Cependant, la limite est donnée par le bruit : il faut que le bruit total, somme quadratique classique du bruit thermique, du bruit "shot" (aussi appelé bruit de Schottky ou bruit photonique) et du bruit en 1/f reste au-dessous du courant généré par l'éclairement d'une surface élémentaire par la source lumineuse LS.

De même, il faut que la dispersion spatiale des caractéristiques des photodiodes n'engendre pas des variations de courant supérieures au courant élémentaire I_{E}, ou alors il faut calibrer la matrice pour soustraire les dispersions éventuelles.

A titre d'exemple, on peut utiliser une matrice de 380 colonnes et 320 lignes, ayant des pixels de 1 mmx1 mm.

Dans ce qui précède on a considéré que la mesure du courant généré par les photodiodes se fait par conversion en tension dans un amplificateur à transimpédance résistif. Un inconvénient est qu'on peut avoir besoin de commuter la valeur des résistances en fonction de l'éclairement pour assurer une adaptation en fonction de l'éclairement.

On peut alternativement utiliser un amplificateur intégrateur (amplificateur à transimpédance capacitive) qui a l'avantage de mieux réguler les paramètres dynamiques des photodiodes, mais a l'inconvénient de ralentir la lecture ou de nécessiter de grosses capacités d'intégration. Cet inconvénient est en partie compensé si on travaille à plus faible éclairement donc à plus faibles courants. On peut moyenner plusieurs lectures de la matrice pour atténuer le bruit.

## Revendications

1. Méthode de comptage d'objets **caractérisée en ce que**
- on utilise un ensemble photosensible (MTR) comprenant au moins un élément photoconducteur, et une source d'éclairement uniforme (LS) pour éclairer l'ensemble photosensible,
- on détermine une référence de courant (I_{E}) fourni par l'ensemble photosensible pour une zone éclairée de cet ensemble correspondant à une surface élémentaire (S_{E}) qui est une fraction déterminée de la surface de l'ensemble photosensible,
- on dispose les objets à compter (OBJ) contre l'ensemble photosensible, on éclaire l'ensemble photosensible par la source, les objets posés masquant une partie de la surface de l'ensemble photosensible,
- on mesure le courant (I_{M}) fourni par l'ensemble, et on détermine la surface masquée par les objets puis le nombre d'objets à partir du courant mesuré et de la référence de courant.

2. Méthode selon la revendication 1, **caractérisée en ce que** l'ensemble photosensible est constitué par une feuille souple revêtue d'un matériau photoconducteur organique imprimé et de conducteurs permettant de recueillir un courant dû à l'éclairement.

3. Méthode selon l'une des revendications 1 et 2, **caractérisée en ce que** l'ensemble photosensible comprend une matrice passive de N lignes et P colonnes (N et P entiers supérieurs ou égaux à 1) d'éléments photoconducteurs situés chacun au croisement entre un conducteur de ligne et un conducteur de colonne de la matrice.

4. Méthode selon la revendication 3, **caractérisée en ce que** la matrice comporte au moins une colonne de référence ayant un nombre connu k (k entier ou nul) de surfaces élémentaires non éclairées, cette colonne servant à déterminer le courant de référence correspondant à l'éclairement d'une seule surface élémentaire.

5. Méthode selon la revendication 4, **caractérisée en ce que** la matrice comprend au moins une autre colonne de référence comportant k' (k' différent de k) surfaces élémentaires non éclairées, et on mesure la différence des courants des deux colonnes de référence pour en déduire le courant généré par l'éclairement d'une seule surface élémentaire.

6. Méthode selon l'une des revendications 4 et 5, **caractérisée en ce que** les colonnes de référence sont dupliquées et les courants fournis par deux colonnes dupliquées sont moyennés.

7. Méthode selon l'une des revendications 3 à 6, **caractérisée en ce qu'**un circuit de lecture est associé à chaque colonne, et ce circuit est différentiel, le circuit mesurant la différence entre le courant fourni par une colonne de référence dont tous les pixels sont éclairés ou tous les pixels sont masqués et le courant fourni par la colonne associée au circuit de lecture.

8. Méthode selon la revendication 7, **caractérisée en ce que** la matrice comporte une seule ligne d'éléments photoconducteurs de forme allongée, la surface élémentaire représentant une fraction de la hauteur d'un élément photoconducteur.

9. Méthode selon l'une des revendications précédentes, **caractérisée en ce que** des circuits de lecture sont associés à chaque colonne mais aussi à chaque ligne de la matrice.

10. Méthode selon l'une des revendications 1 à 3, **caractérisé en ce que** l'ensemble photosensible n'est pas subdivisé en plusieurs éléments photoconducteurs pouvant être lus individuellement ou par colonne mais est constitué par un seul élément photoconducteur dont on lit le courant globalement engendré par l'éclairement.

11. Méthode selon l'une des revendications 1 à 10, **caractérisée en ce que** les éléments photoconducteurs sont des photodiodes.

12. Dispositif de comptage d'objets, comprenant une matrice passive de N lignes et P colonnes (N et P supérieurs ou égaux à 1) d'éléments photoconducteurs, contre laquelle on peut placer les objets pour masquer en partie la matrice, une source de lumière uniforme qui éclaire l'ensemble de la matrice, des moyens de détermination d'un courant élémentaire correspondant à l'éclairement d'une surface élémentaire qui est une fraction de la surface de la matrice, des moyens de mesure d'au moins un courant délivré par la matrice en présence d'objets masquant en partie la matrice, et des moyens de calcul pour déterminer la surface masquée par les objets puis le nombre d'objets à partir du courant délivré et du courant élémentaire.

## Patentansprüche

1. Verfahren zur Zählung von Objekten, **dadurch gekennzeichnet, dass**:
- man eine lichtempfindliche Anordnung (MTR) verwendet, welche mindestens ein lichtleitendes Element und eine einheitliche Beleuchtungsquelle (LS) zum Beleuchten der lichtempfindlichen Anordnung beinhaltet,
- man eine Stromreferenz (I_{E}) bestimmt, welche durch die lichtempfindliche Anordnung für einen beleuchteten Bereich dieser Anordnung bereitgestellt wird, welcher einer Elementaroberfläche (S_{E}) entspricht, welche ein bestimmter Bruchteil der Oberfläche der lichtempfindlichen Anordnung ist,
- man die zu zählenden Objekte (OBJ) an der lichtempfindlichen Anordnung anordnet, man die lichtempfindliche Anordnung durch die Quelle beleuchtet, wobei die aufgestellten Objekte einen Teil der Oberfläche der lichtempfindlichen Anordnung verdecken,
- man den von der Anordnung bereitgestellten Strom (I_{M}) misst, und man die durch die Objekte verdeckte Oberfläche und anschließend die Anzahl der Objekte anhand des gemessenen Stroms und der Stromreferenz bestimmt.

2. Verfahren nach Anspruch 1, **dadurch gekennzeichnet, dass** die lichtempfindliche Anordnung aus einem flexiblen Blatt besteht, welches mit einem gedruckten, organischen, lichtleitenden Material und mit Leitern beschichtet ist, welche es ermöglichen, einen auf die Beleuchtung zurückzuführenden Strom aufzunehmen.

3. Verfahren nach einem der Ansprüche 1 und 2, **dadurch gekennzeichnet, dass** die lichtempfindliche Anordnung eine passive Matrix aus N Zeilen und P Spalten (wobei N und P Ganzzahlen größer als oder gleich 1 sind) von lichtleitenden Elementen beinhaltet, welche jeweils am Schnittpunkt zwischen einem Zeilenleiter und einem Spaltenleiter der Matrix befindlich sind.

4. Verfahren nach Anspruch 3, **dadurch gekennzeichnet, dass** die Matrix mindestens eine Referenzspalte beinhaltet, welche eine bekannte Anzahl k (wobei k eine Ganzzahl oder gleich null ist) von nicht beleuchteten Elementaroberflächen besitzt, wobei diese Spalte zum Bestimmen des Referenzstroms dient, welcher der Beleuchtung einer einzigen Elementaroberfläche entspricht.

5. Verfahren nach Anspruch 4, **dadurch gekennzeichnet, dass** die Matrix mindestens eine andere Referenzspalte beinhaltet, welche k' (wobei k' sich von k unterscheidet) nicht beleuchtete Elementaroberflächen beinhaltet und man die Differenz der Ströme beider Referenzspalten misst, um davon den durch die Beleuchtung einer einzigen Elementaroberfläche erzeugten Strom abzuleiten.

6. Verfahren nach einem der Ansprüche 4 und 5, **dadurch gekennzeichnet, dass** die Referenzspalten dupliziert sind und die von zwei duplizierten Spalten bereitgestellten Ströme gemittelt sind.

7. Verfahren nach einem der Ansprüche 3 bis 6, **dadurch gekennzeichnet, dass** ein Leseschaltkreis mit jeder Spalte verbunden ist, und dieser Schaltkreis differenziell ist, wobei der Schaltkreis die Differenz zwischen dem durch eine Referenzspalte, deren sämtliche Pixel beleuchtet sind, oder deren sämtliche Pixel verdeckt sind, bereitgestellten Strom und dem von der mit dem Leseschaltkreis verbundenen Spalte bereitgestellten Strom misst.

8. Verfahren nach Anspruch 7, **dadurch gekennzeichnet, dass** die Matrix eine einzige Zeile mit lichtleitenden Elementen länglicher Form besitzt, wobei die Elementaroberfläche einen Anteil der Höhe eines lichtleitenden Elements darstellt.

9. Verfahren nach einem der vorhergehenden Ansprüche, **dadurch gekennzeichnet, dass** die Leseschaltkreise mit jeder Spalte, aber auch mit jeder Zeile der Matrix verbunden sind.

10. Verfahren nach einem der Ansprüche 1 bis 3, **dadurch gekennzeichnet, dass** die lichtempfindliche Anordnung nicht in mehrere lichtleitende Elemente unterteilt ist, welche individuell oder spaltenweise gelesen werden können, sondern aus einem einzigen lichtleitenden Element besteht, dessen global durch die Beleuchtung erzeugten Strom man liest.

11. Verfahren nach einem der Ansprüche 1 bis 10, **dadurch gekennzeichnet, dass** die lichtleitenden Elemente Photodioden sind.

12. Vorrichtung zur Zählung von Objekten, welche eine passive Matrix aus N Zeilen und P Spalten (wobei N und P Ganzzahlen gleich oder größer als 1 sind) von lichtleitenden Elementen, an welcher man Objekte platzieren kann, um die Matrix teilweise zu verdecken, eine einheitliche Lichtquelle, welche die gesamte Matrix beleuchtet, Mittel zum Bestimmen eines Elementarstroms, welcher der Beleuchtung einer Elementaroberfläche entspricht, welche ein Bruchteil der Oberfläche der Matrix ist, Mittel zum Messen mindestens eines durch die Matrix im Beisein von Objekten abgegebenen Stroms, welche die Matrix teilweise verdecken, und Mittel zum Bestimmen der durch die Objekte verdeckten Oberfläche und anschließend der Anzahl der Objekte, anhand des abgegebenen Stroms und des Elementarstroms, beinhaltet.

## Claims

1. A method for counting objects **characterized in that**
- a photosensitive assembly (MTR) is used comprising at least one photoconducting element, and a source of uniform illumination (LS) for illuminating the photosensitive assembly,
- a reference current (I_{E}) is determined that is supplied by the photosensitive assembly for an illuminated region of this assembly corresponding to an elementary surface area (S_{E}) which is a determined fraction of the surface area of the photosensitive assembly,
- the objects to be counted (OBJ) are disposed against the photosensitive assembly, the photosensitive assembly is illuminated by the source, the objects disposed masking a part of the surface of the photosensitive assembly,
- the current (I_{M}) supplied by the assembly is measured, and the surface masked by the objects is determined, then the number of objects based on the measured current and on the reference current.

2. The method as claimed in claim 1, **characterized in that** the photosensitive assembly is composed of a flexible sheet coated with a printed photoconducting organic material and of conductors allowing a current due to the illumination to be collected.

3. The method as claimed in either of claims 1 and 2, **characterized in that** the photosensitive assembly comprises a passive matrix of N rows and P columns (N and P integers greater than or equal to 1) of photoconducting elements, each situated at the intersection between a row conductor and a column conductor of the matrix.

4. The method as claimed in claim 3, **characterized in that** the matrix comprises at least one reference column having a known number k (k integer or zero) of non-illuminated elementary surfaces, this column being used to determine the reference current corresponding to the illumination of a single elementary surface area.

5. The method as claimed in claim 4, **characterized in that** the matrix comprises at least one other reference column comprising k' (k' different to k) non-illuminated elementary surfaces, and the difference in the currents of the two reference columns is measured so as to deduce from this the current generated by the illumination of a single elementary surface area.

6. The method as claimed in either of claims 4 and 5, **characterized in that** the reference columns are duplicated and the currents supplied by two duplicated columns are averaged.

7. The method as claimed in one of claims 3 to 6, **characterized in that** a read circuit is associated with each column, and this circuit is differential, the circuit measuring the difference between the current supplied by a reference column all the pixels of which are illuminated or all the pixels of which are masked and the current supplied by the column associated with the read circuit.

8. The method as claimed in claim 7, **characterized in that** the matrix comprises a single row of photoconducting elements with an elongated shape, the elementary surface area representing a fraction of the height of a photoconducting element.

9. The method as claimed in one of the preceding claims, **characterized in that** read circuits are associated with each column but also with each row of the matrix.

10. The method as claimed in one of claims 1 to 3, **characterized in that** the photosensitive assembly is not subdivided into several photoconducting elements that can be read individually or by column, but it is formed by a single photoconducting element whose current, generated by the illumination, is read globally.

11. The method as claimed in one of claims 1 to 10, **characterized in that** the photoconducting elements are photodiodes.

12. A device for counting objects, comprising a passive matrix of N rows and P columns (N and P greater than or equal to 1) of photoconducting elements, against which the objects may be placed so as to mask a part of the matrix, a uniform light source which illuminates the whole of the matrix, means for determining an elementary current corresponding to the illumination of an elementary surface area which is a fraction of the surface area of the matrix, means for measuring at least one current delivered by the matrix in the presence of objects masking a part of the matrix, and calculation means for determining the surface area masked by the objects, then the number of objects based on the current delivered and on the elementary current.
